(19) Europäisches Patentamt
European Patent Office
Office européen des brevets

(11) **EP 3 715 874 B1**

(12) **FASCICULE DE BREVET EUROPEEN**

(45) Date de publication et mention
de la délivrance du brevet:
**19.05.2021 Bulletin 2021/20**

(51) Int Cl.:
***G01R 22/00*** *(2006.01)*   ***G01R 27/16*** *(2006.01)*
***G01R 31/327*** *(2006.01)*

(21) Numéro de dépôt: **20164026.5**

(22) Date de dépôt: **18.03.2020**

(54) **COMPTEUR ELECTRIQUE COMPRENANT UN CIRCUIT DE DETECTION D'UN ETAT OUVERT OU FERME D'UN DISJONCTEUR**

STROMZÄHLER, DER EINEN SCHALTKREIS ZUR ERKENNUNG EINES OFFENEN ODER GESCHLOSSENEN ZUSTANDS EINES LEISTUNGSSCHALTERS UMFASST

ELECTRICITY METER COMPRISING A CIRCUIT FOR DETECTING AN OPEN OR CLOSED STATE OF A CIRCUIT BREAKER

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **25.03.2019 FR 1903098**

(43) Date de publication de la demande:
**30.09.2020 Bulletin 2020/40**

(73) Titulaire: **Sagemcom Energy & Telecom SAS**
**92500 Rueil-Malmaison (FR)**

(72) Inventeurs:
• **TEBOULLE, Henri**
**92500 Rueil Malmaison (FR)**
• **GRINCOURT, Christophe**
**92500 Rueil Malmaison (FR)**
• **JEANROT, Marc**
**92500 Rueil Malmaison (FR)**

(74) Mandataire: **Lavaud, Thomas et al**
**Cabinet Boettcher**
**16, rue Médéric**
**75017 Paris (FR)**

(56) Documents cités:
**EP-A2- 2 304 760    CN-A- 108 767 977**
**FR-A1- 2 987 449**

**Description**

L'invention concerne le domaine des compteurs électriques comprenant un dispositif de coupure interne.

ARRIERE PLAN DE L'INVENTION

Les compteurs électriques modernes sont des compteurs électroniques dits « intelligents » qui sont bien sûr adaptés à mesurer une énergie électrique fournie par un distributeur à une installation électrique via un réseau de distribution, mais qui sont aussi capables de réaliser un certain nombre de fonctions complémentaires : gestion des tarifs par réception d'ordres, relève et programmation à distance, télé-information client, etc.

Ces compteurs électriques comportent parfois un dispositif de coupure interne qui permet de sélectivement connecter et déconnecter, à distance ou depuis le compteur électrique, l'installation électrique du réseau de distribution.

Ainsi, des compteurs électriques monophasés utilisés dans certains pays comportent un conducteur de phase et un conducteur de neutre reliés respectivement à une phase et à un neutre du réseau de distribution, et un dispositif de coupure interne comprenant un organe de coupure de phase monté sur le conducteur de phase et un organe de coupure de neutre monté sur le conducteur de neutre. L'organe de coupure de phase et l'organe de coupure de neutre s'ouvrent et se ferment simultanément.

De même, des compteurs électriques triphasés utilisés dans certains pays comportent trois conducteurs de phase et un conducteur de neutre reliés respectivement aux phases et au neutre du réseau de distribution, et un dispositif de coupure interne comprenant trois organes de coupure de phase montés chacun sur un conducteur de phase distinct. Les organes de coupure de phase s'ouvrent et se ferment simultanément.

Certaines installations électriques sont par ailleurs équipées d'un disjoncteur (externe au compteur électrique) qui est accessible à l'abonné. Le disjoncteur a notamment pour rôle de protéger l'installation électrique de l'abonné en s'ouvrant lorsqu'une surtension, résultant par exemple d'un court-circuit entre deux phases ou entre une phase et le neutre, se produit sur le réseau de distribution.

Lorsque le dispositif de coupure interne et le disjoncteur sont tous deux ouverts et que le courant doit être rétabli, il convient de refermer le dispositif de coupure interne immédiatement après avoir refermé le disjoncteur. Le compteur électrique doit donc pouvoir, en cas d'ouverture du dispositif de coupure interne et du disjoncteur, détecter de manière fiable et robuste la fermeture du disjoncteur par l'abonné afin de refermer le dispositif de coupure interne.

Pour réaliser cette détection, il a été envisagé de monter sur un conducteur de phase d'un compteur électrique un organe de coupure à trois points d'entrée. Deux points d'entrée de l'organe de coupure sont reliés au conducteur de phase de part et d'autre de l'organe de coupure. Le module de communication CPL (pour Courants Porteurs en Ligne) du compteur électrique injecte sur le conducteur de phase via le troisième point d'entrée de l'organe de coupure, lorsque l'organe de coupure est ouvert, un courant correspondant à la porteuse du CPL (35kHz à 91kHz). On mesure alors le courant qui circule en aval de l'organe de coupure et, lorsque celui-ci s'annule, on détecte que le disjoncteur de l'installation est ouvert.

Cette solution nécessite d'utiliser un transformateur pour réaliser une isolation galvanique entre le module de communication CPL et le troisième point d'entrée de l'organe de coupure. Or, un tel transformateur est coûteux et volumineux.

De plus, il n'existe pas aujourd'hui d'organe de coupure à trois points d'entrée dont le développement soit suffisamment abouti pour pouvoir être intégré dans un compteur électrique. Cette solution n'est donc pas mature.

Dans le cas d'un compteur monophasé, cette solution ne permet pas de réaliser la détection de l'état du disjoncteur lorsque le dispositif de coupure interne comporte un organe de coupure de phase monté sur le conducteur de phase et un organe de coupure de neutre monté sur le conducteur de neutre.

Enfin, cette solution ne permet pas de réaliser la détection tout en transmettant des signaux CPL, ce qui est problématique.

Le document FR 2 987 449 A1 dévoile un compteur comprenant un relais de coupure et adapté à détecter l'état ouvert ou fermé dudit relais de coupure.

OBJET DE L'INVENTION

L'invention a pour objet un compteur électrique capable, lorsque son dispositif de coupure interne est ouvert, de détecter si le disjoncteur d'une installation est ouvert ou fermé, ledit compteur électrique surmontant les faiblesses de la solution qui vient d'être décrite.

RESUME DE L'INVENTION

En vue de la réalisation de ce but, on propose un compteur électrique destiné à mesurer une énergie électrique fournie par un réseau de distribution à une installation, le compteur électrique comportant au moins un conducteur de phase et un conducteur de neutre destinés à être reliés respectivement à une phase et à un neutre du réseau de distribution, et un dispositif de coupure interne comprenant au moins un organe de coupure de phase monté sur le conducteur de phase, le compteur électrique comportant en outre au moins un circuit de détection destiné à détecter, lorsque le dispositif de coupure interne est ouvert, si un disjoncteur de l'installation est ouvert ou fermé, et comprenant :

- des composants de couplage comprenant une capacité de couplage et étant reliés, en aval du dispositif de coupure interne, à un conducteur d'injection parmi le conducteur de phase et le conducteur de neutre, et un composant d'injection agencé pour appliquer une tension de référence sur le conducteur d'injection via la capacité de couplage ;
- des composants de liaison reliés à un conducteur de mesure parmi le conducteur de phase et le conducteur de neutre, et un composant de mesure agencé pour mesurer une tension de mesure aux bornes de l'un des composants de liaison, la tension de mesure étant représentative d'une impédance de l'installation.

Le circuit de détection du compteur électrique selon l'invention permet donc, à partir de la tension de mesure, d'évaluer l'impédance de l'installation lorsque le dispositif de coupure interne est ouvert et de détecter grâce à la valeur de l'impédance de l'installation si le disjoncteur de l'installation est ouvert ou fermé.

La tension de référence est appliquée via la capacité de couplage, de sorte que l'utilisation d'un transformateur n'est pas nécessaire.

Le fonctionnement du circuit de détection n'empêche pas le module de communication CPL, qui est avantageusement positionné en amont du dispositif de coupure interne, d'émettre ou de recevoir des signaux CPL.

Le compteur électrique selon l'invention utilise un dispositif de coupure interne parfaitement classique. Les composants utilisés dans le circuit de détection du compteur électrique selon l'invention sont simples et peu coûteux.

La détection de l'état du disjoncteur peut être réalisée quel que soit le type du dispositif de coupure interne intégré dans le compteur électrique et, en particulier, lorsque le dispositif de coupure interne comporte un organe de coupure de phase monté sur le conducteur de phase et un organe de coupure de neutre monté sur le conducteur de neutre (dans le cas d'un compteur monophasé), ou bien lorsque le dispositif de coupure interne comporte plusieurs organes de coupure de phase montés sur plusieurs conducteurs de phase (dans le cas d'un compteur multiphasé).

Le compteur électrique selon l'invention permet donc de détecter de manière robuste, fiable et peu coûteuse, lorsque le dispositif de coupure interne est ouvert, si le disjoncteur de l'installation est ouvert ou fermé.

On propose de plus un compteur électrique tel que celui qui vient d'être décrit, dans lequel le circuit de détection comprend en outre un composant de traitement agencé pour évaluer l'impédance de l'installation à partir de la tension de mesure, et pour détecter à partir de l'impédance de l'installation si le disjoncteur de l'installation est ouvert ou fermé.

On propose de plus un compteur électrique tel que celui qui vient d'être décrit, dans lequel le composant de traitement, le composant d'injection et le composant de mesure sont un seul et même composant.

On propose de plus un compteur électrique tel que celui qui vient d'être décrit, le compteur électrique comportant une partie métrologie et une partie application, le composant de traitement étant un microcontrôleur de la partie application.

On propose de plus un compteur électrique tel que celui qui vient d'être décrit, dans lequel les composants de liaison comprennent un pont de résistances comportant au moins une résistance polarisée.

On propose de plus un compteur électrique tel que celui qui vient d'être décrit, dans lequel les composants de couplage comprennent en outre une résistance de couplage, la capacité de couplage étant reliée au conducteur d'injection via la résistance de couplage.

On propose de plus un compteur électrique tel que celui qui vient d'être décrit, dans lequel les composants de couplage comprennent en outre une inductance de couplage montée entre la capacité de couplage et une masse électrique du compteur électrique.

On propose de plus un compteur électrique tel que celui qui vient d'être décrit, dans lequel le circuit de détection comprend en outre une résistance de ligne montée en aval du dispositif de coupure interne, entre le conducteur de phase et le conducteur de neutre.

On propose de plus un compteur électrique tel que celui qui vient d'être décrit, le compteur électrique étant un compteur monophasé, le dispositif de coupure interne comprenant en outre un organe de coupure de neutre monté sur le conducteur de neutre, le conducteur de phase étant relié à une masse électrique, le conducteur d'injection étant le conducteur de neutre et le conducteur de mesure étant le conducteur de phase, les composants de liaison étant reliés au conducteur de phase en amont et en aval du dispositif de coupure interne.

On propose de plus un compteur électrique tel que celui qui vient d'être décrit, le compteur électrique étant un compteur multiphasé comprenant une pluralité de conducteurs de phase, le dispositif de coupure interne comprenant des organes de coupure de phase montés chacun sur l'un des conducteurs de phase, le conducteur de neutre étant relié à une masse électrique, le conducteur d'injection étant l'un des conducteurs de phase et le conducteur de mesure étant le même conducteur de phase, les composants de liaison étant reliés audit conducteur de phase en aval du dispositif de coupure interne.

On propose de plus un compteur électrique tel que celui qui vient d'être décrit, comprenant plusieurs circuits de détection associés chacun à un conducteur de phase distinct.

On propose de plus un procédé de détection mis en œuvre dans un compteur électrique tel que celui qui vient d'être décrit et destiné à détecter, lorsque le dispositif de coupure interne du compteur électrique est ouvert, si un disjoncteur d'une installation à laquelle est relié le compteur électrique est ouvert ou fermé, comprenant les étapes de :

- ouvrir le dispositif de coupure interne ;
- appliquer la tension de référence sur le conducteur d'injection ;
- mesurer la tension de mesure ;
- évaluer l'impédance de l'installation ;
- détecter si le disjoncteur est ouvert ou fermé à partir d'une valeur de l'impédance de l'installation.

On propose en outre un programme d'ordinateur comprenant des instructions pour mettre en œuvre, par un microcontrôleur d'un compteur électrique, le procédé de détection qui vient d'être décrit.

On propose aussi des moyens de stockage, caractérisés en ce qu'ils stockent un programme d'ordinateur comprenant des instructions pour mettre en œuvre, par un microcontrôleur d'un compteur électrique, le procédé de détection qui vient d'être décrit.

L'invention sera mieux comprise à la lumière de la description qui suit de modes de mise en œuvre particuliers non limitatifs de l'invention.

BREVE DESCRIPTION DES DESSINS

Il sera fait référence aux dessins annexés, parmi lesquels :

[Fig. 1] la figure 1 représente un compteur électrique selon l'invention, le compteur électrique étant un compteur monophasé ;
[Fig. 2] la figure 2 représente un compteur électrique selon l'invention, le compteur électrique étant un compteur triphasé.

DESCRIPTION DETAILLEE DE L'INVENTION

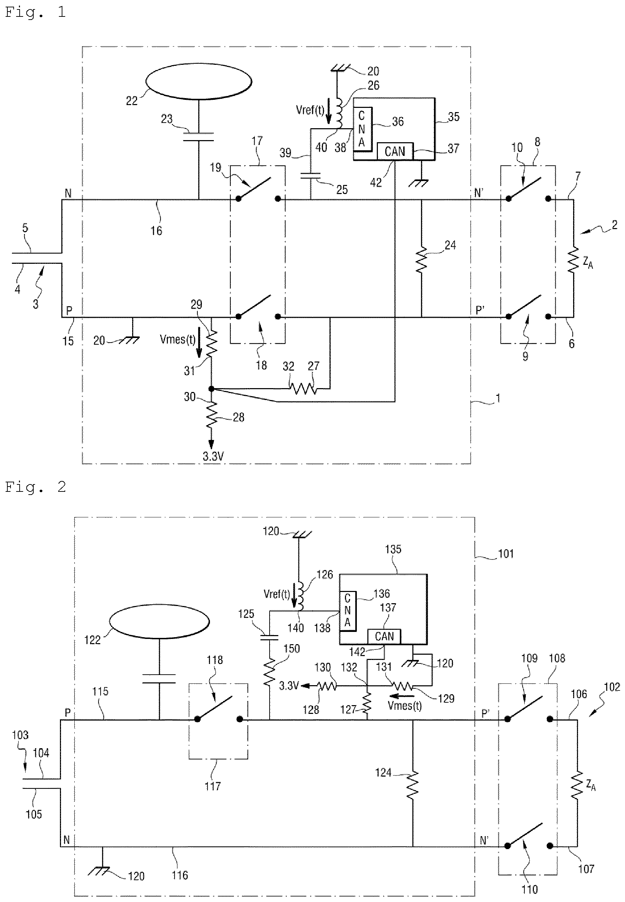

En référence à la figure 1, on décrit tout d'abord un compteur électrique selon l'invention 1 qui est un compteur monophasé.

Le compteur électrique 1 est destiné à mesurer une énergie électrique fournie par un réseau de distribution à une installation 2.

Le réseau de distribution comprend une ligne 3 comportant une phase 4 et un neutre 5.

L'installation 2 est par exemple intégrée dans une habitation d'un abonné. L'installation 2 comprend un ou plusieurs équipements électriques alimentés par le réseau de distribution. L'installation 2 comprend une phase 6 et un neutre 7 qui sont respectivement reliés à la phase 4 et au neutre 5 de la ligne 3 via le compteur électrique 1. L'installation 2 comporte un disjoncteur 8 comprenant un organe de coupure 9 monté sur la phase 6 et un organe de coupure 10 monté sur le neutre 7.

On nomme $Z_A$ l'impédance de l'installation 2.

On nomme $Z_{A\_M}$ l'impédance mesurée par calcul, vue au niveau de l'installation 2 en y intégrant le disjoncteur, qui est égale à $Z_A$ lorsque le disjoncteur 8 est fermé, et à l'impédance vue au niveau de l'installation 2 disjoncteur inclus, lorsque le disjoncteur 8 est ouvert.

Le compteur électrique 1, quant à lui, comprend une borne de phase amont P reliée à la phase 4 de la ligne 3, une borne de phase aval P' reliée à la phase 6 de l'installation 2, une borne de neutre amont N reliée au neutre 5 de la ligne 3 et une borne de neutre aval N' reliée au neutre 7 de l'installation 2.

Dans toute cette demande, par « en amont », on entend du côté du réseau de distribution, et par « en aval », on entend du côté de l'installation 2.

Le compteur électrique 1 comprend un conducteur de phase 15 qui relie entre elles la borne de phase amont P et la borne de phase aval P', et un conducteur de neutre 16 qui relie entre elles la borne de neutre amont N et la borne de neutre aval N'.

Le compteur électrique 1 comporte de plus un dispositif de coupure interne 17 comprenant un organe de coupure de phase 18 monté sur le conducteur de phase 15 et un organe de coupure de neutre 19 monté sur le conducteur de neutre 16.

Le dispositif de coupure interne 17 peut être commandé, depuis le compteur électrique 1 lui-même ou bien depuis l'extérieur, pour sélectivement ouvrir ou fermer le dispositif de coupure interne 17.

L'organe de coupure de phase 18 et l'organe de coupure de neutre 19 du dispositif de coupure interne 17 s'ouvrent et se referment simultanément.

Le conducteur de phase 15 est relié à une masse électrique 20 du compteur électrique 1 en amont de l'organe de coupure de phase 18.

Le compteur électrique 1 comporte de plus un module de communication CPL 22. Le module de communication CPL 22 est ici un modem CPL G3, qui est relié au conducteur de neutre 16 en amont de l'organe de coupure de neutre 19 via une capacité de couplage 23.

Le compteur électrique 1 comporte de plus un circuit de détection qui est destiné à détecter, lorsque le dispositif de coupure interne 17 est ouvert, si le disjoncteur 8 de l'installation 2 est ouvert ou fermé.

Le circuit de détection comprend tout d'abord une résistance de ligne 24 montée en aval du dispositif de coupure interne 17 entre le conducteur de phase 15 et le conducteur de neutre 16. La résistance de ligne 24 a ici une valeur de résistance égale à 1,5MΩ. La résistance de ligne 24 permet d'assurer que la valeur maximale de l'impédance vue du côté de l'abonné (c'est-à-dire de l'installation 2) est égale au maximum à la valeur de résistance de la résistance de ligne 24.

Le circuit de détection comprend de plus des composants de couplage qui sont reliés, en aval du dispositif de coupure interne 17, à un conducteur d'injection parmi le conducteur de phase 15 et le conducteur de neutre 16. On note que les termes « conducteur d'injection » servent juste à désigner le conducteur auquel sont reliés les composants de couplage.

Le conducteur d'injection est ici le conducteur de neutre 16.

Les composants de couplage comprennent une capacité de couplage 25 directement reliée au conducteur de neutre 16, et une inductance de couplage 26 montée entre la capacité de couplage 25 et la masse électrique 20. La valeur de capacité de la capacité de couplage 25 est ici de 10nF. La valeur d'inductance de l'inductance de couplage 26 est ici égale à 1mH.

Le circuit de détection comprend aussi des composants de liaison reliés à un conducteur de mesure parmi le conducteur de phase 15 et le conducteur de neutre 16. Le conducteur de mesure est ici le conducteur de phase 15. Les composants de liaison sont reliés au conducteur de phase 15 en amont et en aval du dispositif de coupure interne 17. On note à nouveau que les termes « conducteur de mesure » servent juste à désigner le conducteur auquel sont reliés les composants de liaison.

Les composants de liaison comprennent une première résistance 27, une deuxième résistance 28 et une troisième résistance 29.

La première résistance 27 est reliée au conducteur de phase 15 en aval de l'organe de coupure de phase 18. La deuxième résistance 28 est une résistance polarisée, ici par une tension égale à 3,3V. La troisième résistance 29 est reliée au conducteur de phase 15 en amont de l'organe de coupure de phase 18 (et donc à la masse électrique 20). La borne 30 de la deuxième résistance 28 qui n'est pas connectée à la tension de 3,3V est reliée à la borne 31 de la troisième résistance 29 qui n'est pas reliée au conducteur de phase 15. La borne 32 de la première résistance 27 qui n'est pas reliée au conducteur de phase 15 est reliée à la borne 30 de la deuxième résistance 28 et à la borne 31 de la troisième résistance 29.

La première résistance 27 a ici une valeur de résistance égale à 500kΩ, alors que la deuxième résistance 28 et la troisième résistance 29 ont chacune une valeur de résistance égale à 10kΩ.

Le circuit de détection comprend de plus un composant d'injection agencé pour appliquer une tension de référence sur le conducteur d'injection via la capacité de couplage 25.

Le composant d'injection est un microcontrôleur 35 et, plus précisément, le microcontrôleur d'une partie application du compteur électrique 1.

Le compteur électrique 1 comprend en effet une partie métrologie, comportant un microcontrôleur, et une partie application, comportant un autre microcontrôleur (qui est le microcontrôleur 35).

La partie métrologie est notamment dédiée aux mesures de tension et de courant destinées à évaluer l'énergie électrique consommée par l'installation 2. La partie application est notamment dédiée à la mise en œuvre des communications via le module de communication CPL 22, à la gestion des calendriers tarifaires, des courbes de charges, etc. La partie métrologie et la partie application sont « étanches », c'est-à-dire qu'un dysfonctionnement de la partie application ne peut pas perturber le fonctionnement de la partie métrologie. La partie métrologie n'est pas « téléchargeable », c'est-à-dire qu'il n'est pas possible de télécharger un logiciel dans la partie métrologie depuis l'extérieur. La partie application est téléchargeable.

Le microcontrôleur 35 intègre un convertisseur numérique analogique 36 et un convertisseur analogique numérique 37.

Une sortie 38 du microcontrôleur 35, qui est aussi une sortie du convertisseur numérique analogique 36, est reliée à la borne 39 de la capacité de couplage 25 qui n'est pas reliée au conducteur de neutre 16 et à la borne 40 de l'inductance de couplage 26 qui n'est pas reliée à la masse électrique 20.

Le microcontrôleur 35 génère et applique la tension de référence Vref(t) sur le conducteur d'injection, c'est-à-dire sur le conducteur de neutre 16, via la capacité de couplage 25.

La tension de référence Vref(t) est une tension analogique produite par le convertisseur numérique analogique 36 du microcontrôleur 35. La tension de référence Vref(t) est un signal sinusoïdal d'amplitude crête $V_A$ et de fréquence Y. $V_A$ est par exemple égale à 1V.

La fréquence Y est une fréquence élevée par rapport à la fréquence du courant distribué par le réseau de distribution, qui est ici égale à 50Hz. La fréquence Y est ici égale à 120kHz.

La capacité de couplage 25 et l'inductance de couplage 26 forment ainsi un circuit de couplage. Le circuit de couplage sert, d'une part, à injecter le 120kHz à travers la capacité de couplage 25 dans le cas où le dispositif de coupure interne 17 est ouvert, et d'autre part, à évacuer le 50Hz via l'inductance de couplage 26 lorsque le dispositif de coupure interne 17 est fermé.

On note que le fait d'injecter à « haute fréquence » permet de diminuer la valeur de capacité de la capacité de couplage 25 et la valeur d'inductance de l'inductance de couplage 26, et donc de réduire leur coût et leur encombrement. Le 120kHz est par ailleurs éloigné de la borne maximale de la porteuse du CPL (91kHz) ce qui permet d'éviter toute perturbation des communications CPL par le circuit de détection.

Le circuit de détection comprend aussi un composant de mesure agencé pour mesurer une tension de mesure aux bornes de l'un des composants de liaison.

Le composant de mesure est le microcontrôleur 35. Une entrée 42 du microcontrôleur 35, qui est aussi une entrée du convertisseur analogique numérique 37, est reliée à la borne 30 de la deuxième résistance 28 et à la borne 31 de la troisième résistance 29. Le microcontrôleur 35 acquiert une tension de mesure Vmes(t) aux bornes de la troisième résistance 29. La tension de mesure Vmes(t) est numérisée par le convertisseur analogique numérique 37.

Le circuit de détection comporte de plus un composant de traitement qui évalue l'impédance $Z_{A\_M}$ de l'installation 2 à partir de la tension de référence Vref(t) et de la tension de mesure Vmes(t), et qui détermine si le disjoncteur 8 est ouvert ou fermé à partir de l'impédance $Z_{A\_M}$ de l'installation 2. Le composant de traitement est le microcontrôleur 35.

On explique maintenant le fonctionnement du circuit de détection.

La tension de mesure Vmes(t) a une amplitude crête égale à $V_B$.

On a :

$$\frac{Z_{A\_M} \times R_2}{Z_{A\_M} + R_2} = \left[ \frac{R \times (V_A - V_B)}{2V_B - 3.3} \right] - R_1 = Z,$$

et donc :

$$Z_{A\_M} = \frac{Z \times R_2}{R_2 - Z} \ ,$$

où $R_2$ est la valeur de résistance de la résistance de ligne 24, $R_1$ est la valeur de résistance de la première résistance 27, et où R est la valeur de résistance de la deuxième résistance 28 et de la troisième résistance 29.

On considère que la valeur minimale de l'impédance mesurée $Z_{A\_M}$ de l'installation 2 est de 200kΩ lorsque le disjoncteur 8 est ouvert et la valeur maximale de l'impédance mesurée $Z_{A\_M}$ de l'installation 2 est de 20kΩ lorsque le disjoncteur 8 est fermé.

Le microcontrôleur 35 évalue donc la valeur de $Z_{A\_M}$, à partir de la tension de référence et de la tension de mesure, et, en fonction de la valeur de $Z_{A\_M}$, détecte un état ouvert ou un état fermé du disjoncteur 8.

Ainsi :

- si $Z_{A\_M} \geq 200$kΩ, le microcontrôleur 35 détecte que le disjoncteur 8 est ouvert ;
- si $Z_{A\_M} \leq 20$kΩ, le microcontrôleur 35 détecte que le disjoncteur 8 est fermé ;
- sinon, le microcontrôleur 35 produit un message d'alerte à destination du Système d'Information (SI) par courants porteurs en lignes, en utilisant le module de communication CPL 22.

Bien sûr, la valeur de $Z_{A\_M}$ prise en compte par le microcontrôleur 35 peut être obtenue à partir d'une mesure unique, ou bien à partir d'une pluralité de mesures, et, en particulier, peut être une moyenne de valeurs d'impédance obtenues à partir de plusieurs mesures.

Lorsque le microcontrôleur 35 détecte un état fermé du disjoncteur 8, le microcontrôleur 35 ferme instantanément le dispositif de coupure interne 17.

On note que la position du module de communication CPL 22 en amont du dispositif de coupure interne 17 permet à celui-ci de fonctionner lorsque le dispositif de coupure interne 17 est ouvert et que le circuit de détection réalise la détection de l'état ouvert ou fermé du disjoncteur 8.

On note aussi que l'utilisation du microcontrôleur de la partie application pour réaliser la détection est particulièrement astucieuse. On utilise en effet un composant préexistant pour réaliser une nouvelle fonction, ce qui permet de réduire le coût et les difficultés de développement de cette nouvelle fonction.

En référence à la figure 2, on décrit maintenant un compteur électrique 101 selon l'invention qui est un compteur triphasé.

La ligne 103 comprend cette fois trois phases 104 et un neutre 105. Une seule phase 104 est représentée sur la figure 2.

L'installation 102 comprend elle aussi trois phases 106 et un neutre 107. Une seule phase 106 est représentée sur la figure 2.

Les trois phases 106 et le neutre 107 de l'installation 102 sont reliés aux phases 104 et au neutre 105 de la ligne 103 via le compteur électrique 101.

L'installation 102 comprend un disjoncteur 108 comprenant un organe de coupure 109 monté sur chaque phase 106, et un organe de coupure 110 monté sur le neutre 107.

Le compteur électrique 101, quant à lui, comprend trois bornes de phase amont P reliées aux phases 104 de la ligne 103, trois bornes de phase aval P' reliées aux phases 106 de l'installation 102, une borne de neutre amont N reliée au neutre 105 de la ligne 103 et une borne de neutre aval N' reliée au neutre 107 de l'installation 102.

Le compteur électrique 101 comprend trois conducteurs de phase 115 et un conducteur de neutre 116. Un seul conducteur de phase 115 est représenté sur la figure 2.

Le conducteur de neutre 116 est relié à la masse électrique 120.

Le compteur électrique 101 comporte de plus un dispositif de coupure interne 117 comprenant trois organes de coupure de phase 118 montés chacun sur l'un des conducteurs de phase 115.

Dans un premier mode de réalisation, visible sur la figure 3, on réalise la détection en injectant sur un seul conducteur d'injection qui est l'un des conducteurs de phase 115 du compteur électrique 101. Le conducteur de mesure est le même conducteur de phase 115.

Le circuit de détection comprend à nouveau une résistance de ligne 124 montée en aval du dispositif de coupure interne 117 entre le conducteur de phase 115 (qui est le conducteur d'injection) et le conducteur de neutre 116. La résistance de ligne 124 a une valeur de résistance égale à 1,5MΩ.

Le circuit de détection comprend de plus des composants de couplage reliés, en aval du dispositif de coupure interne 117, au conducteur de phase 115.

Les composants de couplage comprennent une résistance de couplage 150 directement reliée au conducteur de phase 115, une capacité de couplage 125 et une inductance de couplage 126. La capacité de couplage 125 est montée entre la résistance de couplage 150 et l'inductance de couplage 126. L'inductance de couplage 126 a une borne reliée à la masse électrique 120. La capacité de couplage 125 a une borne reliée à une borne de la résistance de couplage 150 qui n'est pas reliée au conducteur de phase 115, et une borne reliée à une borne de l'inductance de couplage 126 qui n'est pas reliée à la masse électrique 120.

La valeur de résistance de la résistance de couplage 150 est ici de 500kΩ. La valeur de capacité de la capacité de couplage 125 est ici de 10nF. La valeur d'inductance de l'inductance de couplage 126 est ici égale à 1mH.

Le circuit de détection comprend aussi des composants de liaison reliés au conducteur de phase 115 en aval du dispositif de coupure interne 117.

Les composants de liaison comprennent une première résistance 127, une deuxième résistance 128 et une troisième résistance 129. Les composants de liaison sont reliés au conducteur de phase 115 en aval du dispositif de coupure interne 117.

La première résistance 127 est reliée au conducteur de phase 115 en aval de l'organe de coupure de phase 118. La deuxième résistance 128 est une résistance polarisée, ici par une tension égale à 3,3V. La troisième résistance 129 est reliée à la masse électrique 120. La borne 130 de la deuxième résistance 128 qui n'est pas connectée à la tension de 3,3V est reliée à la borne 131 de la troisième résistance 129 qui n'est pas reliée à la masse électrique 120. La borne 132 de la première résistance 127 qui n'est pas reliée au conducteur de phase 115 est reliée à la borne 130 de la deuxième résistance 128 et à la borne 131 de la troisième résistance 129.

La première résistance 127 a ici une valeur de résistance égale à 500kΩ, alors que la deuxième résistance 128 et la troisième résistance 129 ont chacune une valeur de résistance égale à 10kΩ.

Le circuit de détection comprend de plus un composant d'injection agencé pour appliquer une tension de référence sur le conducteur d'injection via l'un au moins des composants de couplage.

Le composant d'injection est un microcontrôleur 135 et, plus précisément le microcontrôleur de la partie application du compteur électrique 101.

Le microcontrôleur 135 intègre notamment un convertisseur numérique analogique 136 et un convertisseur analogique numérique 137.

Une sortie 138 du microcontrôleur 135, qui est aussi une sortie du convertisseur numérique analogique 136, est reliée à la borne 140 de l'inductance de couplage 126 qui n'est pas reliée à la masse électrique 120.

Le microcontrôleur 135 génère et applique la tension de référence Vref(t) sur le conducteur d'injection, c'est-à-dire sur le conducteur de phase 115, via la capacité de couplage 125 et la résistance de couplage 150.

La tension de référence Vref(t) est une tension analogique produite par le convertisseur numérique analogique 136 du microcontrôleur 135. La tension de référence Vref(t) est un signal sinusoïdal d'amplitude crête $V_A$ et de fréquence Y.

$V_A$ est par exemple égale à 1V, et la fréquence Y est ici égale à 120kHz.

La résistance de couplage 150, la capacité de couplage 125 et l'inductance de couplage 126 forment ainsi un circuit de couplage. Le circuit de couplage sert, d'une part, à injecter le 120kHz à travers la capacité de couplage 125 et la résistance de couplage 150 dans le cas où le dispositif de coupure interne 117 est ouvert, et d'autre part, à évacuer le 50Hz via l'inductance de couplage 126 lorsque le dispositif de coupure interne 117 est fermé.

On note que le fait d'injecter à « haute fréquence » permet de diminuer la valeur de capacité de la capacité de couplage 125 et la valeur d'inductance de l'inductance de couplage 126, et donc de réduire leur coût et leur encombrement.

Le circuit de détection comprend aussi un composant de mesure agencé pour mesurer une tension de mesure aux bornes de l'un des composants de liaison.

Le composant de mesure est le microcontrôleur 135. Une entrée 142 du microcontrôleur 135, qui est aussi une entrée du convertisseur analogique numérique 137, est reliée à la borne 130 de la deuxième résistance 128 et à la borne 131 de la troisième résistance 129. Le microcontrôleur 135 acquiert une tension de mesure Vmes(t) aux bornes de la troisième résistance 129. La tension de mesure Vmes(t) est numérisée par le convertisseur analogique numérique 137.

Le circuit de détection comporte de plus un composant de traitement qui évalue une impédance de l'installation à partir de la tension de référence Vref(t) et de la tension de mesure Vmes(t). Le composant de traitement est le microcontrôleur 135.

On explique maintenant le fonctionnement du circuit de détection.

La tension de mesure Vmes(t) a une amplitude crête égale à $V_B$.

On a :

$$\frac{Z_{A\_M} \times R_2}{Z_{A\_M} + R_2} = \frac{R_0 \times [V_B \times (2 + \frac{R}{R_1}) - 3.3]}{V_A \times \frac{R}{R_1} + 3.3 \times \left(1 + \frac{R_0}{R_1}\right) - V_B \times \left(2 + \frac{R + 2R_0}{R_1}\right)} = Z$$

et donc :

$$Z_{A\_M} = \frac{Z \times R_2}{R_2 - Z} \ ,$$

où $R_0$ est la valeur de résistance de la résistance de couplage 150, $R_2$ est la valeur de résistance de la résistance de ligne 124, $R_1$ est la valeur de résistance de la première résistance 127, et où R est la valeur de résistance de la deuxième résistance 128 et de la troisième résistance 129.

On considère que la valeur minimale de l'impédance mesurée $Z_{A\_M}$ de l'installation 102 est de 200kΩ lorsque le disjoncteur 108 est ouvert et la valeur maximale de l'impédance mesurée $Z_{A\_M}$ de l'installation 2 est de 20kΩ lorsque le disjoncteur 108 est fermé.

Le microcontrôleur 135 évalue donc la valeur de $Z_{A\_M}$, à partir de la tension de référence et de la tension de mesure, et, en fonction de la valeur de $Z_{A\_M}$, détecte un état ouvert ou un état fermé du disjoncteur 108.

Ainsi :

- si $Z_{A\_M} \geq 200$kΩ, le microcontrôleur 135 détecte que le disjoncteur 108 est ouvert ;
- si $Z_{A\_M} \leq 20$kΩ, le microcontrôleur 135 détecte que le disjoncteur 108 est fermé ;
- sinon, le microcontrôleur 135 produit un message d'alerte à destination du Système d'Information (SI) par courants porteurs en lignes, en utilisant le modem CPL G3 122.

Lorsque le microcontrôleur 135 détecte un état fermé du disjoncteur 108, le microcontrôleur 135 ferme instantanément le dispositif de coupure interne 117.

Le compteur électrique 101 comprend donc des composants de couplage 125, 126, 150 et des composants de liaison 127, 128, 129 reliés à un seul conducteur de phase 115 (celui qui est visible sur la figure 2).

Alternativement, on pourrait avoir une pluralité de circuits de détection associés chacun à un conducteur de phase distinct d'un compteur électrique multiphasé.

Le compteur électrique comprend alors, pour chaque conducteur de phase, les composants de couplage et les composants de liaison.

Les composants d'injection et les composants de mesure sont formés par le microcontrôleur de la partie application. Le convertisseur numérique analogique (et donc le microcontrôleur) comprend trois sorties (dans le cas d'un compteur triphasé) utilisées chacune pour injecter la tension de référence sur l'un des conducteurs de phase via les composants de couplage associés audit conducteur de phase. Le convertisseur analogique numérique (et donc le microcontrôleur) comprend trois entrées (dans le cas d'un compteur triphasé) utilisées chacune pour mesurer la tension de mesure aux bornes de la deuxième résistance des composants de liaison associés audit conducteur de phase. Chaque conducteur de phase est ainsi à la fois le conducteur d'injection et le conducteur de mesure pour les composants de couplage et les composants de liaison qui lui sont associés.

En répétant le circuit de détection sur chaque conducteur de phase, on peut détecter une anomalie sur le disjoncteur, et notamment des états ouvert/fermé différents sur des organes de coupure du disjoncteur, ce qui est impossible sans un dysfonctionnement du disjoncteur.

Dans ce cas, le microcontrôleur produit un message d'alerte à destination du Système d'Information (SI). Cette solution permet donc une gestion des anomalies plus élaborée.

Bien entendu, l'invention n'est pas limitée aux modes de réalisation décrits mais englobe toute variante entrant dans le champ de l'invention telle que définie par les revendications.

Les valeurs numériques présentées sont fournies pour illustrer la mise en œuvre de l'invention et peuvent bien sûr être différentes.

L'invention s'applique bien sûr aux compteurs monophasés et aux compteurs multiphasés (pas uniquement triphasés).

**Revendications**

1. Compteur électrique (1 ; 101) destiné à mesurer une énergie électrique fournie par un réseau de distribution à une installation (2 ; 102), le compteur électrique comportant au moins un conducteur de phase (15 ; 115) et un conducteur de neutre (16 ; 116) destinés à être reliés respectivement à une phase et à un neutre du réseau de distribution, et un dispositif de coupure interne (17 ; 117) comprenant au moins un organe de coupure de phase (18 ; 118) monté sur le conducteur de phase, le compteur électrique étant **caractérisé en ce qu'**il comporte en outre au moins un circuit de détection destiné à détecter, lorsque le dispositif de coupure interne est ouvert, si un disjoncteur (8 ; 108) de l'installation est ouvert ou fermé, et comprenant :

   - des composants de couplage comprenant une capacité de couplage (25 ; 125) et étant reliés, en aval du dispositif de coupure interne, à un conducteur d'injection parmi le conducteur de phase et le conducteur de neutre, et un composant d'injection agencé pour appliquer une tension de référence (Vref(t)) sur le conducteur d'injection via la capacité de couplage ;
   - des composants de liaison reliés à un conducteur de mesure parmi le conducteur de phase et le conducteur de neutre, et un composant de mesure agencé pour mesurer une tension de mesure (Vmes(t)) aux bornes de l'un des composants de liaison, la tension de mesure étant représentative d'une impédance de l'installation.

2. Compteur électrique selon la revendication 1, dans lequel le circuit de détection comprend en outre un composant de traitement (35 ; 135) agencé pour évaluer l'impédance de l'installation à partir de la tension de mesure, et pour détecter à partir de l'impédance de l'installation si le disjoncteur de l'installation est ouvert ou fermé.

3. Compteur électrique selon la revendication 2, dans lequel le composant de traitement, le composant d'injection et le composant de mesure sont un seul et même composant.

4. Compteur électrique selon la revendication 2, le compteur électrique comportant une partie métrologie et une partie application, le composant de traitement étant un microcontrôleur (35 ; 135) de la partie application.

5. Compteur électrique selon l'une des revendications précédentes, dans lequel les composants de liaison comprennent un pont de résistances comportant au moins une résistance polarisée (28 ; 128).

**6.** Compteur électrique selon l'une des revendications précédentes, dans lequel les composants de couplage comprennent en outre une résistance de couplage (150), la capacité de couplage étant reliée au conducteur d'injection via la résistance de couplage.

**7.** Compteur électrique selon l'une des revendications précédentes, dans lequel les composants de couplage comprennent en outre une inductance de couplage (26 ; 126) montée entre la capacité de couplage et une masse électrique du compteur électrique.

**8.** Compteur électrique selon l'une des revendications précédentes, dans lequel le circuit de détection comprend en outre une résistance de ligne (24 ; 124) montée en aval du dispositif de coupure interne, entre le conducteur de phase et le conducteur de neutre.

**9.** Compteur électrique selon l'une des revendications précédentes, le compteur électrique étant un compteur monophasé (1), le dispositif de coupure interne (17) comprenant en outre un organe de coupure de neutre (19) monté sur le conducteur de neutre, le conducteur de phase étant relié à une masse électrique (20), le conducteur d'injection étant le conducteur de neutre et le conducteur de mesure étant le conducteur de phase, les composants de liaison étant reliés au conducteur de phase en amont et en aval du dispositif de coupure interne.

**10.** Compteur électrique selon l'une des revendications 1 à 8, le compteur électrique étant un compteur multiphasé (101) comprenant une pluralité de conducteurs de phase (115), le dispositif de coupure interne (117) comprenant des organes de coupure de phase (118) montés chacun sur l'un des conducteurs de phase, le conducteur de neutre étant relié à une masse électrique (120), le conducteur d'injection étant l'un des conducteurs de phase et le conducteur de mesure étant le même conducteur de phase, les composants de liaison étant reliés audit conducteur de phase en aval du dispositif de coupure interne.

**11.** Compteur électrique selon la revendication 10, comprenant plusieurs circuits de détection associés chacun à un conducteur de phase distinct.

**12.** Procédé de détection mis en œuvre dans un compteur électrique selon l'une des revendications précédentes et destiné à détecter, lorsque le dispositif de coupure interne du compteur électrique est ouvert, si un disjoncteur d'une installation à laquelle est relié le compteur électrique est ouvert ou fermé, comprenant les étapes de :

- ouvrir le dispositif de coupure interne ;
- appliquer la tension de référence sur le conducteur d'injection ;
- mesurer la tension de mesure ;
- évaluer l'impédance de l'installation ;
- détecter si le disjoncteur est ouvert ou fermé à partir d'une valeur de l'impédance de l'installation.

**13.** Programme d'ordinateur comprenant des instructions pour mettre en œuvre, par un microcontrôleur d'un compteur électrique, le procédé de détection selon la revendication 12.

**14.** Moyens de stockage, **caractérisés en ce qu'**ils stockent un programme d'ordinateur comprenant des instructions pour mettre en œuvre, par un microcontrôleur d'un compteur électrique, le procédé de détection selon la revendication 12.

**Patentansprüche**

**1.** Stromzähler (1; 101), der dazu bestimmt ist, einen Strom zu messen, der von einem Verteilungsnetz an eine Anlage (2; 102) geliefert wird, wobei der Stromzähler mindestens einen Phasenleiter (15; 115) und einen Neutralleiter (16; 116) umfasst, die dazu bestimmt sind, mit einer Phase bzw. mit einer Neutralpunkt des Verteilungsnetzes verbunden zu werden, und eine interne Unterbrechungsvorrichtung (17; 117), die mindestens ein Phasenunterbrechungsorgan (18; 118) umfasst, das auf den Phasenleiter geschaltet ist, wobei der Stromzähler **dadurch gekennzeichnet ist, dass** er ferner mindestens eine Detektionsschaltung umfasst, die dazu bestimmt ist, bei offener interner Unterbrechungsvorrichtung zu erfassen, ob ein Schutzschalter (8; 108) der Anlage offen oder geschlossen ist; und umfassend:

- Kopplungskomponenten, die eine Kopplungskapazität (25; 125) umfassen und stromabwärts der internen Kopplungsvorrichtung mit einem Einkopplungsleiter unter dem Phasenleiter und dem Neutralleiter verbunden sind, und eine Einkopplungskomponente, die ausgebildet ist, um eine Referenzspannung (Vref(t)) an dem Einkopplungsleiter über die Kopplungskapazität anzulegen;
- Verbindungskomponenten, die mit einem Messleiter unter dem Phasenleiter und dem Neutralleiter verbunden sind, und eine Messkomponente, die ausgebildet ist, um eine Messspannung (Vmes(t)) an den Klemmen einer der Verbindungskomponenten zu messen, wobei die Messspannung repräsentativ für eine Impedanz der Anlage ist.

2. Stromzähler nach Anspruch 1, bei dem die Detektionsschaltung ferner eine Verarbeitungskomponente (35; 135) umfasst, die ausgebildet ist, um die Impedanz der Anlage anhand der Messspannung zu schätzen und um anhand der Impedanz der Anlage zu erfassen, ob der Schutzschalter offen oder geschlossen ist.

3. Stromzähler nach Anspruch 2, bei dem die Verarbeitungskomponente, die Einkopplungskomponente und die Messkomponente ein und dieselbe Komponente sind.

4. Stromzähler nach Anspruch 2, wobei der Stromzähler ein metrologisches Teil und ein Anwendungsteil umfasst, wobei die Verarbeitungskomponente ein Mikrocontroller (35; 135) des Anwendungsteils ist.

5. Stromzähler nach einem der vorhergehenden Ansprüche, bei dem die Verbindungskomponenten eine Widerstandsbrücke umfassen, die mindestens einen polarisierten Widerstand (28; 128) umfasst.

6. Stromzähler nach einem der vorhergehenden Ansprüche, bei dem die Kopplungskomponenten ferner einen Kopplungswiderstand (150) umfassen, wobei die Kopplungskapazität mit dem Einkopplungsleiter über den Kopplungswiderstand verbunden ist.

7. Stromzähler nach einem der vorhergehenden Ansprüche, bei dem die Kopplungskomponenten ferner eine Kopplungsinduktivität (26; 126) umfassen, die zwischen die Kopplungskapazität und eine elektrische Masse des Stromzählers geschaltet ist.

8. Stromzähler nach einem der vorhergehenden Ansprüche, bei dem die Detektionsschaltung ferner einen Leitungswiderstand (24; 124) umfasst, der stromabwärts der internen Unterbrechungsvorrichtung zwischen den Phasenleiter und den Neutralleiter geschaltet ist.

9. Stromzähler nach einem der vorhergehenden Ansprüche, wobei der Stromzähler ein einphasiger Zähler (1) ist, wobei die interne Unterbrechungsvorrichtung (17) ferner ein Neutral-Unterbrechungsorgan (19) umfasst, das auf den Neutralleiter geschaltet ist, wobei der Phasenleiter mit einer elektrischen Masse (20) verbunden ist, wobei der Einkopplungsleiter der Neutralleiter ist und der Messleiter der Phasenleiter ist, wobei die Verbindungskomponenten mit dem Phasenleiter stromaufwärts und stromabwärts der internen Unterbrechungsvorrichtung verbunden sind.

10. Stromzähler nach einem der Ansprüche 1 bis 8, wobei der Stromzähler ein mehrphasiger Zähler (101) ist, der eine Vielzahl von Phasenleitern (115) umfasst, wobei die interne Unterbrechungsvorrichtung (117) Phasen-Unterbrechungsorgane (118) umfasst, die jeweils auf einen der Phasenleiter geschaltet sind, wobei der Neutralleiter mit einer elektrischen Masse (120) verbunden ist, wobei der Einkopplungsleiter einer der Phasenleiter und der Messleiter derselbe Phasenleiter ist, wobei die Verbindungskomponenten mit dem Phasenleiter stromabwärts der internen Unterbrechungsvorrichtung verbunden sind.

11. Stromzähler nach Anspruch 10, umfassend mehrere Detektionsschaltungen, die jeweils mit einem anderen Phasenleiter verbunden sind.

12. Detektionsverfahren, das in einem Stromzähler nach einem der vorhergehenden Ansprüche durchgeführt wird und dazu bestimmt ist, bei offener interner Unterbrechungsvorrichtung des Stromzählers zu erfassen, ob ein Schutzschalter einer Anlage, an die der Stromzähler angeschlossen ist, offen oder geschlossen ist, umfassend die Schritte:

- Öffnen der internen Unterbrechungsvorrichtung;
- Anlegen der Referenzspannung an den Einkopplungsleiter;
- Messen der Messspannung;
- Schätzen der Impedanz der Anlage;
- Erfassen anhand eines Wertes der Impedanz der Anlage, ob der Schutzschalter offen oder geschlossen ist.

**13.** Computerprogramm, umfassend Anweisungen zum Durchführen des Detektionsverfahren nach Anspruch 12 mittels eines Mikrocontrollers eines Stromzählers.

**14.** Speichermittel, die **dadurch gekennzeichnet sind, dass** sie ein Computerprogramm speichern, das Anweisungen zum Durchführen des Detektionsverfahrens nach Anspruch 12 mittels eines Mikrocontrollers umfasst.

**Claims**

**1.** An electricity meter (1; 101) for measuring the amount of electrical energy that is delivered by a distribution network to an installation (2; 102), the electricity meter comprising at least one phase conductor (15; 115) and a neutral conductor (16; 116) for connecting respectively to a phase line and to a neutral line of the distribution network, and an internal cut-off device (17; 117) comprising at least one phase cut-off member (18; 118) connected in series with the phase conductor, the electricity meter being **characterized in that** it further includes at least one detector circuit for acting when the internal cut-off device is open to detect whether a circuit breaker (8; 108) of the installation is open or closed, and comprising:

• coupling components comprising a coupling capacitor (25; 125) and connected, downstream from the internal cut-off device, to an injection conductor selected from the phase conductor and the neutral conductor, and an injection component arranged to apply a reference voltage (Vref(t)) to the injection conductor via the coupling capacitor;
• connection components connected to a measurement conductor selected from the phase conductor and the neutral conductor, and a measurement component arranged to measure a measurement voltage (Vmes(t)) across the terminals of one of the connection components, the measurement voltage being representative of an impedance of the installation.

**2.** An electricity meter according to claim 1, wherein the detector circuit further comprises a processor component (35; 135) arranged to evaluate the impedance of the installation from the measurement voltage, and to use the impedance of the installation to detect whether the circuit breaker of the installation is open or closed.

**3.** An electricity meter according to claim 2, wherein the processor component, the injection component, and the measurement component are a single component.

**4.** An electricity meter according to claim 2, the electricity meter comprising a measurement portion and an application portion, and the processor component is a microcontroller (35; 135) of the application portion.

**5.** An electricity meter according to any preceding claim, wherein the connection components comprise a resistor bridge including at least one bias resistor (28; 128).

**6.** An electricity meter according to any preceding claim, wherein the coupling components further comprise a coupling resistor (150), the coupling capacitor being connected to the injection conductor via the coupling resistor.

**7.** An electricity meter according to any preceding claim, wherein the coupling components further comprise a coupling inductor (26; 126) connected between the coupling capacitor and an electrical ground of the electricity meter.

**8.** An electricity meter according to any preceding claim, wherein the detector circuit further comprises a line resistor (24; 124) connected downstream from the internal cut-off device, between the phase conductor and the neutral conductor.

**9.** An electricity meter according to any preceding claim, the electricity meter being a single-phase meter (1), and the internal cut-off device (17) further comprising a neutral cut-off member (19) connected in series with the neutral conductor, the phase conductor being connected to an electrical ground (20), the injection conductor being the neutral conductor and the measurement conductor being the phase conductor, the connection components being connected to the phase conductor both upstream and downstream from the internal cut-off device.

**10.** An electricity meter according to any one of claims 1 to 8, the electricity meter being a multi-phase meter (101) having a plurality of phase conductors (115), the internal cut-off device (117) comprising a plurality of phase cut-off members (118), each connected in series with a respective one of the phase conductors, the neutral conductor being connected to an electrical ground (120), the injection conductor being one of the phase conductors and the measurement conductor being the same phase conductor, the connection components being connected to said phase conductor downstream from the internal cut-off device.

11. An electricity meter according to claim 10, comprising a plurality of detector circuits, each associated with a distinct phase conductor.

12. A detection method performed by an electricity meter according to any preceding claim, and serving, when the internal cut-off device of the electricity meter is open, to detect whether a circuit breaker of an installation to which the electricity meter is connected is open or closed, the method comprising the steps of:

   • opening the internal cut-off device;
   • applying the reference voltage to the injection conductor;
   • measuring the measurement voltage;
   • evaluating the impedance of the installation;
   • detecting whether the circuit breaker is open or closed on the basis of a value for the impedance of the installation.

13. A computer program comprising instructions for enabling a microcontroller of an electricity meter to perform the detection method according to claim 12.

14. Storage means **characterized in that** they store a computer program comprising instructions for enabling a microcontroller of an electricity meter to perform the detection method according to claim 12.

Fig. 1

Fig. 2

**RÉFÉRENCES CITÉES DANS LA DESCRIPTION**

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- FR 2987449 A1